Europäisches Patentamt

European Patent Office

Office européen des brevets

(11) Veröffentlichungsnummer: **0 239 033**
**A1**

(12) **EUROPÄISCHE PATENTANMELDUNG**

(21) Anmeldenummer: 87104138.0

(22) Anmeldetag: 20.03.87

(51) Int. Cl.⁴: **H 05 K 3/42**

(30) Priorität: 26.03.86 DE 3610114

(43) Veröffentlichungstag der Anmeldung: 30.09.87
Patentblatt 87/40

(84) Benannte Vertragsstaaten: CH DE FR GB IT LI NL

(71) Anmelder: Schöffel, Manfred, Dipl.-Ing., Rohlsdorfer
Weg 33, D-2409 Techau (DE)

(72) Erfinder: Schöffel, Manfred, Dipl.-Ing., Rohlsdorfer
Weg 33, D-2409 Techau (DE)

(74) Vertreter: Schöning, Hans-Werner, Dipl.-Ing.,
Patentanwälte Dipl.-Phys. Ole Niedmers Dipl.-Ing. Hans
W. Schöning Jessenstrasse 4, D-2000 Hamburg 50 (DE)

(54) Schaltungsträgerplatte für Laborzwecke und Verfahren zu ihrer Herstellung.

(57) Schaltungsträgerplatten aus isolierendem Substrat werden zum Aufbau von elektrischen Leitungsanordnungen verwendet und sind auf einer oder beiden Plattenseiten (11, 12) mit einer elektrisch leitfähigen Schicht (13, 14) versehen und weisen eine Mehrzahl durch die Schaltungsträgerplatte (10) hindurchgehende Bohrungen (15) auf. Die Wandungen (16) der Bohrungen sind durch eine elektrisch leitfähige Schicht (17) abgedeckt, die die Schichten (13, 14) elektrisch leitend verbinden. Eine derartige Platte wird in dieser Form in einem festen Verteilungsmuster der Bohrungen (15) hergestellt und anschliessend mit einem Resistmaterial ein- oder beidseitig bedeckt. In einem vom Anwender vorzunehmenden Verfahrensschritt kann dann entsprechend dem Muster des Resistmaterials (18) das Leiterbahnenmuster auf das Resistmaterial (18) übertragen werden, wobei anschliessend in einem Ätzverfahren die übrige elektrisch leitfähige Schicht (13, 14) weggeätzt wird.

1

Manfred Schöffel, Rohlsdorfer Weg 33, 2409 Techau

Schaltungsträgerplatte für Laborzwecke und Verfahren zu ihrer Herstellung

Beschreibung

Die Erfindung betrifft eine Schaltungsträgerplatte aus isolierendem Substrat, insbesondere für Laborzwecke, bei der eine Plattenseite mit einer elektrisch leitfähigen Schicht versehen ist, und die eine Mehrzahl durch die Schaltungsträgerplatte hindurchgehende Bohrungen aufweist, wobei die Wandungen der Bohrungen jeweils durch eine elektrisch leitfähige Schicht abgedeckt sind, die mit der Schicht auf der Plattenseite elektrisch leitend verbunden sind, sowie ein Verfahren zur Herstellung einer derartigen Schaltungsträgerplatte.

Schaltungsträgerplatten und Verfahren zu ihrer Herstellung sind seit langem bekannt, wobei derartige Schaltungsträgerplatten grundsätzlich erst dann konstruiert und hergestellt werden, wenn die Laborentwicklung einer elektrischen Schaltungsanordnung abgeschlossen ist. Wegen der verhältnismäßig hohen Herstellungskosten für die Konstruktion einer derartigen Schaltungsträgerplatte und die aufwendige und damit zeit- und kostenintensive Einrichtung der Vorrichtung zur Herstellung einer derartigen Schaltungsträgerplatte werden Schaltungsanordnungen im Labor zunächst auf sogenannten Laborplatinen aufgebaut, deren äußere Kontur zwar in der Regel schon der endgültigen Kontur der späteren massenweise zu fertigenden Schaltungsträgerplatte entspricht, die jedoch an ihren Plattenseiten vorkonfektionierte elektrisch leitende Leiterbahnen aufweist, und Bohrungen in einem vorbestimmten Raster, die zum Aufbau einer Schaltungsanordnung in Verbindung mit den Leiterbahnen wahlweise benutzt werden können.

Es hat sich jedoch in der Laborpraxis gezeigt, daß mit zunehmenden Packungsgrad, d. h. mit einer zunehmenden Anzahl von auf der Schaltungsträgerplatte anzuordnenden Schaltungselementen, insbesondere wenn diese noch auf beiden Plattenseiten angeordnet sind und über entsprechende Bohrungen durch die Schaltungsträgerplatte hindurch elektrisch leitend verbunden sein müssen, daß einerseits die Fehlerquellen, verursacht durch mangelnden elektrischen Kontakt, sich enorm vergrößern und andererseits, daß wegen des schaltungsbedingten hohen Packungsgrades ein derartig geforderter hoher Bepackungsgrad mit Bauelementen auf diesen Laborplatinen nicht möglich ist. Der Laborentwickler ist deshalb bisher gezwungen, um zumindest für Laborzwecke ein funktionierendes Schaltungslabormuster zu erstellen, die Schaltungsanordnung auf mehreren Laborplatinen der bisherigen Art aufzubauen, um wenigsten ein einwandfreies Funktionieren für Laborzwecke zu erreichen.

Vielfach ist es jedoch nicht möglich, sich derart zu behelfen, da bei sehr schnellen elektronischen Schaltungen die Länge der Leiterbahnen auf der Schaltungsträgerplatte entscheidend in die Funktion der Schaltungsanordnung eingeht, so daß der Laborentwickler gezwungen ist, auch sein Labormuster schon entsprechend einer später massenweise zu fertigenden Schaltungsträgerplatte aufzubauen. Dabei treten dann, wie vorangehend dargelegt, die auf alle Fälle zu vermeidenden Probleme auf, insbesondere elektrisch fehlerhafte Verbindungen durch die Bohrungen hindurch, die normalerweise die auf der jeweiligen Plattenseite der Schaltungsträgerplatte angeordneten Leiterbahnen elektrisch einwandfrei verbinden sollen.

Hilfslösungen, beispielsweise dünne Drähte durch die Bohrungen hindurchzuführen und mit den entsprechenden Leiterbahnen zu verbinden oder das Einsetzen von kleinen Hohlnieten in die entsprechenden Bohrungen sind aus Zeit- und Kostengründen völlig unakzeptabel und schaffen wegen der damit verbundenen enormen Fehlerquellen in bezug auf eine einwandfreie elektrische Leitung keine akzeptable Lösung des vorangehend aufgezeichneten Problems.

Es ist Aufgabe der vorliegenden Erfindung, eine Schaltungsträgerplatte insbesondere für Laborzwecke sowie ein Verfahren zu ihrer Herstellung zu schaffen, die im Labor leicht herstellbar bzw. leicht ausführbar sind, wobei die derart hergestellte Schaltungsträgerplatte die gleiche Sicherheit bietet wie eine in Serie gefertigte Schaltungsträgerplatte nach den bekannten Verfahren und die zu so geringen Kosten bereitgestellt werden kann, wie die bisherigen vorgefertigten sogenannten Labor- bzw. Entwicklungsplatinen.

Gelöst wird die Aufgabe gem. der Erfindung dadurch, daß die die eine Plattenseite bedeckende leitfähige Schicht im wesentlichen vollständig von einem Resistmaterial abgedeckt ist, das ebenfalls die Bohrungen bedeckt.

Der Vorteil dieser Art der Ausbildung der Schaltungsträgerplatte liegt darin, daß der Laborentwickler eine Schaltungsträgerplatine zur Verfügung hat, die sich in einem derart konfektionierten Stadium befindet, daß er lediglich noch entsprechend eines vorgegebenen Schemas die einzelnen Löcher bzw. Bohrungen der Schaltungsträgerplatte mit geeigneten Mitteln markierend miteinander verbinden muß und danach die nicht gebrauchte elektrisch leitfähige Schicht außerhalb dieser Schicht wegätzen muß, wobei er nicht befürchten muß, daß die elektrisch leitfähige Schicht an den Bohrungswandungen weggeätzt wird. Die fertige Schaltungsträgerplatte schafft nach diesem Ätzvorgang die gleiche Sicherheit in bezug auf einwandfreie Kontakte durch die Bohrungen hindurch wie bisher massenweise gefertigte Schaltungsträgerplatten nach den bekannten Verfahren.

Gem. einer vorteilhaften Ausführungsform sind die Bohrungen in der Schaltungsträgerplatte derart bedeckt, daß die elektrisch leitfähigen Bohrungswandungen von dem Resistmaterial abgedeckt sind. Diese Ausführungsform schafft noch eine größere Sicherheit gegenüber der Bedeckung der Bohrungen durch die Resistschicht, da die Resistschicht als solche grundsätzlich bewußt verhältnismäßig dünn ausgebildet ist und es bei leichter mechanischer Beschädigung des Filmes passieren kann, daß die leitfähige Schicht beim Ätzvorgang innerhalb der Bohrung so weggeätzt wird, daß eine elektrisch leitende Verbindung durch die Bohrung nicht mehr gegeben ist.

Besonders vorteilhaft ist es, gem. einer anderen Ausführungsform der Schaltungsträgerplatte, beide Plattenseiten im wesentlichen vollständig mit einer leitfähigen Schicht und einer diese jeweils im wesentlichen vollständig abdeckenden Schicht aus Resistmaterial abzudecken. Bei dieser Ausführungsform handelt es sich wegen der beidseitigen Beschichtung des isolierenden Substrats in bezug auf den grundsätzlichen Aufbau um die klassische Form der beidseitig beschichteten Schaltungsträgerplatte. Insbesondere diese Art der Ausbildung ist für hohe Packungsdichten in bezug auf die Anzahl der darauf anzuordnenden Bauelemente sehr geeignet, da hiermit schon für eine Labormusterbeschaltungsanordnung der Schaltungselemente so vorgenommen werden kann, wie sie später für die endgültig massenweise zu fertigende Schaltungsträgerplatine vorgenommen wird.

Das Verfahren zur Herstellung der Schaltungsträgerplatte weist lösungsgem. folgende Herstellungsschritte auf:

Aufbringen der die Plattenseite der Schaltungsträgerplatte im wesentlichen vollständig bedeckenden leitfähigen Schicht,

Bohren aller Löcher der Schaltungsträgerplatte nach einem vorgegebenen festen Lochverteilungsmuster,

Ausbilden der die Bohrungswandungen bedeckenden und die auf der einen Plattenseite ausgebildete Schicht elektrisch verbindenden Schicht,

Aufbringen einer Schicht aus Resistmaterial auf die leitfähige Schicht auf der einen Plattenseite und

teilweises Wegätzen der elektrisch leitfähigen Schicht entsprechend eines zuvor durch das Resistmaterial geformten Leiterbahnenmusters.

Der Vorteil dieses Verfahrens liegt im wesentlichen darin, daß die ersten drei Verfahrensschritte schon unmittelbar werkseitig bei der Grobherstellung der Schaltungsträgerplatte ausgeführt werden können, d. h. die Schaltungsträgerplatte kann grundsätzlich auf diese Weise großflächig hergestellt, d. h. vorkonfektioniert bereitgestellt werden, wobei der Laborentwickler sich dann eine Schaltungsträgerplatte gem. der von ihm gewünschten Größe zurechtschneiden- bzw. sägen kann. Darüberhinaus ist es aber auch möglich, in bestimmten vorkonfektionierten Abmaßen, Schaltungsträgerplatten verschiedener Größen bereitzustellen. In allen Fällen ist aber dafür gesorgt, daß die leitfähige Verbindung durch die Bohrungen hindurch sicher vorgefertigt ist und Kontaktprobleme wie bei bisherigen Laborplatinen nicht auftreten. Ein wesentlicher Vorteil dieses Verfahrens ist, daß der Laborentwickler dann lediglich die letzten beiden Verfahrensschritte entsprechend der auszubildenden Schaltungsverbindungen im Labor selbst durchführen muß bzw. kann, ohne daß die Sicherheit der elektrischen Leitung durch die Bohrung hindurch in Mitleidenschaft gezogen wird.

Gem. einer vorteilhaften Weiterbildung des Verfahrens werden auf beide Plattenseiten jeweils vollständig bedeckende leitfähige Schichten aufgebracht, die durch die auf den Bohrungswandungen nachfolgend ausgebildete Schicht elektrisch verbunden werden, wobei anschließend auf beide leitfähige Schichten eine Schicht aus Resistmaterial aufgebracht wird. Auf diese Weise werden auch für Laborzwecke mit der gleichen Betriebssicherheit doppelseitige Schaltungsträgerplatten geschaffen, wie sie bisher nur mit massenweise nach individuellem Aufbauschema gefertigte Schaltungsträgerplatten möglich war.

Vorzugsweise kann das Verfahren so ausgeführt werden, daß das Resistmaterial die Bohrlochöffnungen überdeckend aufgebracht wird, d. h., daß die Bohrlochöffnungen filmartig überspannt werden.

Ein derartiger die Bohrlochöffnungen überdeckender Film aus Resistmaterial ist gegen mechanische Beanspruchung jedoch verhältnismäßig instabil, so daß es gem. einer anderen vorteilhaften Art der Ausführung des Verfahrens sinnvoll ist, daß Resistmaterial derart aufzubringen, daß es in die Bohrungen eindringt und die die Bohrungswandungen bedeckende elektrisch leitfähige Schicht schichtartig bedeckt. Das Resistmaterial kann dabei die Bohrung als solche vollkommen ausfüllen, es kann jedoch auch genügen, daß das Resistmaterial sich lediglich bedeckend auf die Bohrungswandungen auflegt und dabei ein Bohrloch mit vermindertem Durchmesser noch freigelassen wird.

Zur Ausführung des Verfahrens kann vorteilhafterweise Resistmaterial beliebiger Art aufgebracht werden, wobei das Resistmaterial Photoresistmaterial sein kann, u. z. positives oder auch negatives Photoresistmaterial. Diese Photoresistmaterialien können auf bekannte Weise über Filmpositive bzw. Filmnegative, die den Verlauf der zu übertragenden Leiterbahnen bestimmen, belichtet werden. Die unbelichtete bzw. die belichtete elektrisch leitfähige Schicht auf der Schaltungsträgerplatte kann dann, je nach Art des Photoresistmaterials, weggeätzt werden. Darüberhinaus ist es grundsätzlich auch möglich, daß Verfahren derart auszuführen, daß das Resistmaterial im Siebdruck oder ähnlichen Auftragungsverfahren auf die Oberfläche der elektrisch leitfähigen Schicht bzw. Schichten übertragen wird. Schließlich ist es auch möglich, daß Resistmaterial per Hand durch geeignete Schreibgeräte aufzutragen, wobei auf diese Weise auch schnell Korrekturen der Leiterbahnführungen vorgenommen werden können, wenn beispielsweise zuvor die Leiterbahnen über-/ -tive bzw. Positive auf das Photoresistmaterial übertragen worden sind.

Die Erfindung wird nun unter Bezugnahme auf die nachfolgenden schematischen Zeichnungen anhand eines Ausführungsbeispiels eingehend beschrieben. Darin zeigen:

Fig. 1 eine Schaltungsträgerplatte, die beidseitig in einem ersten Verfahrensschritt mit einer elektrisch leitfähigen Schicht versehen worden ist,

Fig. 2 die in Fig. 1 dargestellte Schaltungsträgerplatte im Schnitt in einem nächsten Verfahrensschritt, bei dem eine Bohrung ausgeführt worden ist,

Fig. 3 die Schaltungsträgerplatte im Schnitt in einem nächsten Verfahrensschritt, bei dem die Bohrungswandung mit einer leitfähigen Bohrungswandungsschicht versehen ist,

Fig. 4      die Schaltungsträgerplatte im Schnitt, bei der in
einem nächsten Verfahrensschritt das Resistmaterial die Bohrlochöffnungen filmartig bedeckend aufgebracht ist,

Fig. 5      eine gegenüber der Darstellung von Fig. 4      andere Art der Ausführung des Verfahrens, bei  dem
das Resistmaterial die leitfähige Bohrwandungsschicht
bedeckt und

Fig. 6      die Schaltungsträgerplatte nach Ausführung des letzten Verfahrensschritts, bei dem  die elektrisch
leitfähigen Schichten bis auf bestimmungsgem.      verbleibende Leiterbahnen weggeätzt sind.

Die Schaltungsträgerplatte 10 besteht im wesentlichen aus einem
isolierendem Substrat, wobei dieses Substrat sogenanntes glasfaserverstärktes Epoxydharz sein kann oder auch Pertinax, es
kann aber auch aus beliebigen anderen geeigneten isolierenden
Materialien bestehen. Auf die erste und zweite Plattenseite 11,
12 wird dann auf bekannte Weise eine im wesentlichen diese Seiten vollständig bedeckende leitfähige Schicht aufgebracht, die
in der Regel aus Kupfer besteht; grundsätzlich aber auch aus beliebigen anderen leitfähigen und ätzbaren Materialien bestehen
kann.

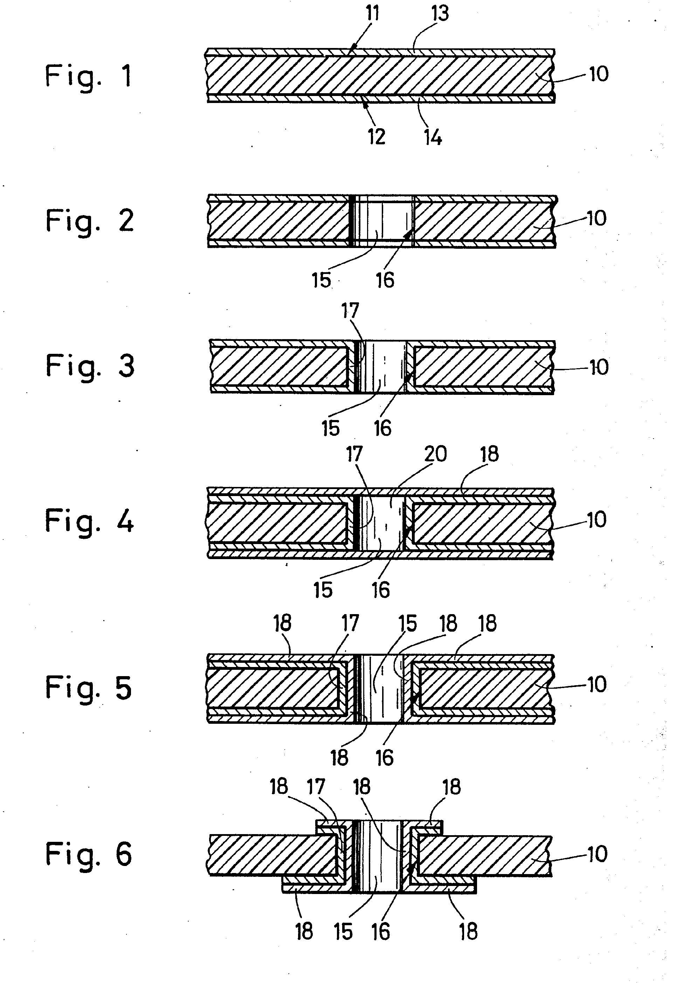

Es sei darauf verwiesen, daß die Darstellungen der Schaltungsträgerplatte gem. Fig. 1 bis Fig. 6 eine sogenannte doppelt-
bzw. zweiseitig beschichtete Schaltungsträgerplatte bzw. Leiterplatte zeigen. Das Verfahren zur Herstellung derartiger Schaltungsträgerplatten 10 kann aber auch dann angewendet werden, wenn lediglich eine Plattenseite mit einer leitfähigen Schicht
versehen ist, aber die Bohrungen 15 selbst mit einer die Bohrungswandungen 16 bedeckenden leitfähigen Schicht 17 versehen
werden müssen. Derartige Anwendungsfälle sind beispielsweise
dann gegeben, wenn die in die Bohrungen 15 einzusetzenden Anschlußdrähte von Schaltungsbauteilen auch mechanisch sehr
sicher in den Bohrungen gehalten werden müssen oder auch dann,
wenn diese Bauteile auf der Seite der leitfähigen Schicht
auf der Schaltungsträgerplatte 10 aufgebaut sein müssen.

Die einzelnen Verfahrensschritte zur Schaffung einer derartigen
einseitig beschichteten Schaltungsträgerplatte 10 sind im Prinzip genau die gleichen wie bei der Ausbildung einer zweiseitig
beschichteten Schaltungsträgerplatte 10, so daß an dieser Stelle
nicht gesondert darauf eingegangen zu werden braucht.

In einem nächsten Verfahrensschritt entsprechend der Darstellung
von Fig. 2 sind Bohrungen 15 nach einem vorgegebenen festen
Lochverteilungsmuster in der Schaltungsträgerplatte 10 ausgeführt, wobei dieses Lochverteilungsmuster zur Aufnahme von integrierten Bausteinen, Widerständen, Kondensatoren oder dgl.
dienen kann, d. h. das Lochverteilungsmuster wird durch vorgegebene Abstände dieser Bauteile und ihrer entsprechender Anzahl pro einer bestimmten Fläche der Schaltungsträgerplatte 10
festgelegt.

In einem nächsten Verfahrensschritt, wie er in Fig. 3 dargestellt
ist, werden sämtliche Bohrungen 15 an ihren Bohrungswandungen
16 mit einer elektrisch leitfähigen Schicht versehen, wobei die
Ausbildung dieser elektrisch leitfähigen Schicht 17 bei allen
Bohrungen 15 gleichzeitig ausgeführt wird. Das Ergebnis dieses
Verfahrensschrittes ist, daß die Schaltungsträgerplatte 10 noch
vollständig beschichtet eine Vielzahl von Bohrungen 15 aufweist,
die beide elektrisch leitfähigen Schichten 13, 14 elektrisch
leitend miteinander verbinden.

Nachfolgend wird eine Schicht aus Resistmaterial 18 auf beide leitfähigen Schichten 13, 14 aufgebracht, die gem. der Darstellung von Fig. 4 auch die Bohrlochöffnungen 20 filmartig bedecken. Bis zu diesem Verfahrensschritt kann die Schaltungsträgerplatte 10 vorkonfektioniert werden, d. h., es wird eine Schaltungsträgerplatte 10 bereitgestellt, die beidseitig mit einer elektrisch leitfähigen Schicht 13, 14 beschichtet ist, die mit Bohrungen 15 versehen ist, wobei die Bohrungen 15 mit leitfähigen Bohrungswandungsschichten 17 versehen sind, die beide elektrisch leitfähigen Schichten 13, 14 elektrisch miteinander verbinden. Bei der Schaltungsträgerplatte 10 sind insgesamt die elektrisch leitfähigen Schichten 13, 14 ebenso wie die Bohrungsöffnungen 20 mit der Resistmaterialschicht 18 abgedeckt.

Der Anwender kann dann, wenn das Resistmaterial beispielsweise positives oder negatives Photoresistmaterial ist, entsprechend einem Positiv oder Negativ, auf dem die vorgegebennen Leiterverbindungen zu beiden Plattenseiten vorgegeben sind, das Photoresistmaterial über diese Positive oder Negative belichten, wobei nachfolgend auf bekannte Weise der unbelichtete bzw. der belichtete Teil des Photoresistmaterials einschließlich der darunter liegenden elektrisch leitfähigen Schicht 13, 14 weggeätzt wird, wie es in Fig. 6 nach Abschluß des Ätzvorganges beispielhaft dargestellt ist.

Die Schaltungsträgerplatte 10 gem. der Darstellung von Fig. 4 unterscheidet sich von der gem. der Darstellung von Fig. 5 dadurch, daß bei der Schaltungsträgerplatte 10 gem. Fig. 10 das Resistmaterial 18 auf der leitfähigen Bohrungswandungsschicht 17 aufgebracht ist, wobei durch diesen abgewandelten Verfahrensschritt eine gegenüber der Ausführungsform von Fig. 10 sicherere Abdeckung geschaffen wird, da die filmartige Überspannung der Bohrlochöffnung 20 gegen mechanische Beanspruchung weniger stabil bei Lagerung und Handhabung ist.

Wenn das Resistmaterial 18 darüberhinaus auch noch lötfähige oder die Lötfähigkeit verhältnismäßig gering beeinflussende Eigenschaften aufweist, kann es auch sinnvoll sein, das Resistmaterial 18 insgesamt in die Bohrung 15 hineinlaufen und diese vollständig ausfüllen zu lassen, was hier nicht besonders dargestellt ist.

Es sei noch darauf verwiesen, daß als Resistmaterial grundsätzlich nicht nur Photoresistmaterial in Frage kommt, vielmehr ist es auch denkbar, das Resistmaterial beispielsweise durch Siebdruck entsprechend einem vorgegebenen Leitungsschema aufzutragen und die durch das Resistmaterial nicht bedeckten Flächen der leitfähigen Schichten 13, 14 wegzuätzen. Auch ist es möglich, das Resistmaterial beispielsweise in Form von Handschreibgeräten aufzubringen oder auf beliebige andere hier nicht gesondert dargestellte Weise.

Mit dem hier beschriebenen Verfahren wird eine Schaltungsträgerplatte 10 insbesondere für Laborzwecke geschaffen, die die gleiche elektrische Sicherheit wie in Serien gefertigte Schaltungsträgerplatten nach den herkömmlichen bekannten Verfahren bieten. Das hat zur Folge, daß nun auch für Laborzwecke die Schaltungsanordnung im wesentlichen so aufgebaut sein kann, wie sie für spätere Serienfertigung aufgebaut sein wird.

Ein weiterer Vorteil der Erfindung liegt darin, daß das Bohren der Löcher für die Aufnahme der Bauelemente weitgehend entfällt. Dies erforderte bei den bisher in den Labors angewandten Verfahren zur Herstellung von Schaltungsträgern ein hohes Maß an Präzision und damit einen hohen Zeitaufwand, verbunden mit zusätzlichen Fehlerquellen.

Bezugszeichenliste

10 Schaltungsträgerplatte

11 erste Plattenseite

12 zweite   "

13 erste elektrisch leitfähige Schicht

14 zweite   "          "          "

15 Bohrung

16 Bohrungswandung

17 leitfähige Bohrungswandungsschicht

18 Resistmaterial

19

20 Bohrungsöffnung

13

Manfred Schöffel, Rohlsdorfer Weg 33, 2409 Techau

Schaltungsträgerplatte für Laborzwecke und Verfahren zu ihrer
Herstellung

Patentansprüche

1. Schaltungsträgerplatte aus isolierendem Substrat, insbesondere für Laborzwecke, bei der eine Plattenseite mit einer
elektrisch leitfähigen Schicht versehen ist, und die eine
Mehrzahl durch die Schaltungsträgerplatte hindurchgehende
Bohrungen aufweist, wobei die Wandungen der Bohrungen jeweils
durch eine elektrisch leitfähige Schicht abgedeckt sind, die
mit der Schicht auf der Plattenseite elektrisch leitend verbunden sind, dadurch gekennzeichnet, daß die die eine Plattenseite (11) bedeckende leitfähige Schicht (13) im weșentlichen
vollständig von einem Resistmaterial (18) abgedeckt ist, das
ebenfalls die Bohrungen (15) bedeckt.

2. Schaltungsträgerplatte nach Anspruch 1, dadurch gekennzeichnet, daß die Bohrungen (15) derart bedeckt sind, daß die elektrisch leitfähigen Wandungen (16) von dem Resistmaterial (18)
abgedeckt sind.

3. Schaltungsträgerplatte nach einem oder beiden der Ansprüche 1 oder 2, dadurch gekennzeichnet, daß beide Plattenseiten (11, 12) im wesentlichen vollständig von einer elektrisch leitfähigen Schicht (13, 14) und einer diese jeweils im wesentlichen vollständig abdeckenden Schicht aus Resistmaterial (18) abgedeckt sind.

4. Verfahren zur Herstellung einer Schaltungsträgerplatte aus isolierendem Substrat, insbesondere für Laborzwecke nach einem oder mehreren der Ansprüche 1 bis 3, gekennzeichnet durch folgende Herstellungsschritte:

Aufbringen der die eine Plattenseite der Schaltungsplatte im wesentlichen vollständig bedeckenden leitfähigen Schicht,

Bohren aller Löcher der Schaltungsträgerplatte nach einem vorgegebenen festen Lochverteilungsmuster,

Ausbilden der die Bohrungswandungen bedeckenden und die auf der einen Plattenseite ausgebildete Schicht elektrisch verbindende Schicht,

Aufbringen einer Schicht aus Resistmaterial auf die leitfähige Schicht auf der einen Plattenseite und

teilweises Wegätzen der elektrischen leitfähigen Schicht entsprechend eines zuvor durch das Resistmaterial geformten Leiterbahnenmusters.

5. Verfahren nach Anspruch 4, dadurch gekennzeichnet, daß auf beide Plattenseiten jeweils diese vollständig bedeckende leitfähige Schichten aufgebracht werden, die durch die auf den Bohrungswandungen nachfolgend ausgebildete Schicht elektrisch verbunden werden, wobei anschließend auf beide leitfähigen Schichten eine Schicht aus Resisistmaterial aufgebracht wird.

6. Verfahren nach einem oder beiden der Ansprüche 4 oder 5, dadurch gekennzeichnet, daß das Resistmaterial die Bohrlochöffnungen überdeckend aufgebracht wird.

7. Verfahren nach einem oder beiden der Ansprüche 4 oder 5, dadurch gekennzeichnet, daß das Resistmaterial derart aufgebracht wird, daß es in die Bohrungen eindringt und die die Bohrungswandungen bedeckende elektrische leitfähige Schicht schichtartig bedeckt.

8. Verfahren nach einem oder mehreren der Ansprüche 4 bis 7, dadurch gekennzeichnet, daß als Resistmaterial Photoresistmaterial aufgebracht wird.

9. Verfahren nach Anspruch 8, dadurch gekennzeichnet, daß als Resistmaterial positives Photoresistmaterial aufgebracht wird.

10. Verfahren nach Anspruch 8, dadurch gekennzeichnet, daß als Resistmaterial negatives Photoresistmaterial aufgebracht wird.

Fig. 1

Fig. 2

Fig. 3

Fig. 4

Fig. 5

Fig. 6

0 239 033

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 154 909 (HOECHST AG) <br><br> * Seite 4, Zeile 28 - Seite 5, Zeile 16; Seite 11, Zeile 24 - Seite 12, Zeile 3; Ansprüche 1-2, 6, 10 * | 1-6,8-10 | H 05 K 3/42 |
| | --- | | |
| A | DE-A-3 108 080 (DAINIPPON SCREEN MANUFACTURING CO.) <br> * Seite 3, Zeile 20 - Seite 4, Zeile 12; Figuren 1a-1e * | 1-4 | |
| | --- | | |
| P,A | DE-A-3 611 157 (IBIDEN K.K.) <br> * Seite 7, Zeilen 10-20 * | 1 | |
| | ----- | | |

|  |
|---|
| RECHERCHIERTE SACHGEBIETE (Int. Cl.4) |
| H 05 K 3/00 |

Der vorliegende Recherchenbericht wurde für alle Patentansprüche erstellt.

| Recherchenort | Abschlußdatum der Recherche | Prüfer |
|---|---|---|
| BERLIN | 25-06-1987 | LEOUFFRE M. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82